# EUROPÄISCHE PATENTSCHRIFT

(11) **EP 0 944 924 B1**
(45) Veröffentlichungstag und Bekanntmachung des Hinweises auf die Patenterteilung: **23.10.2002**
(21) Anmeldenummer: 97918885.1
(22) Anmeldetag: 13.08.1997
(51) Int. Cl.: H01L 31/0236, H01L 33/00

(54) **VERFAHREN ZUM HERSTELLEN EINES LICHT AUSSENDENDEN UND/ODER EMPFANGENDEN HALBLEITERKÖRPERS**
PROCESS FOR PRODUCING A LIGHT-EMITTING AND/OR LIGHT-RECEIVING SEMICONDUCTOR BODY
PROCEDE POUR FABRIQUER UN CORPS SEMI-CONDUCTEUR EMETTANT ET/OU RECEVANT DE LA LUMIERE

(30) Priorität: 13.08.1996 DE 19632627
(43) Veröffentlichungstag der Anmeldung: 29.09.1999
(73) Patentinhaber: Osram Opto Semiconductors GmbH & Co. OHG, 93049 Regensburg (DE)
(72) Erfinder: FISCHER, Helmut, 93138 Lappersdorf (DE); NIRSCHL, Ernst, D-93173 Wenzenbach (DE); WEGLEITER, Walter, D-93152 Nittendorf (DE)
(74) Vertreter: Epping, Wilhelm, Dipl.-Ing.
(86) Internationale Anmeldenummer: DE9701729
(87) Internationale Veröffentlichungsnummer: WO98007195

(56) Entgegenhaltungen:
- EP-A- 0 198 199
- EP-A- 0 584 599
- US-A- 4 582 952
- US-A- 5 429 954
- HUO D T C ET AL: "CHEMICAL CLEANING OF GRATINGS IN DISTRIBUTED FEEDBACK INP LASERS" JOURNAL OF THE ELECTROCHEMICAL SOCIETY, Bd. 137, Nr. 11, 1.November 1990, Seiten 3639-3642, XP000161442

## Beschreibung

Die Erfindung bezieht sich auf ein Verfahren zum Herstellen eines Licht aussendenden und/oder empfangenden Halbleiterkörpers mit mindestens einer Halbleiterschicht, die aus GaAsₓP₁₋ₓ mit 0 ≤ x < 1 besteht.

Leuchtdioden mit derartigen Halbleiterkörpern sind bekannt. So ist beispielsweise in der europäischen Patentanmeldung EP 584 599 ein Leuchtdiodenchip beschrieben, bei dem auf einem n-leitenden GaP-Substrat eine n-leitende GaP-Epitaxieschicht und auf dieser eine p-leitende GaP-Epitaxieschicht aufgebracht ist. Die Unterseite des GaP-Substrats ist mit einer Kontaktmetallisierung aus einer Au-Ge-Legierung versehen und auf der Oberseite der p-leitenden GaP-Epitaxieschicht ist eine Kontaktmetallisierung aufgebracht, die sich ausgehend von der p-leitenden GaP-Epitaxieschicht beispielsweise aus einer Au-Schicht, einer Au-Zn-Schicht, einer Ti-W-N-Schicht und einer Au- oder Al-Schicht zusammensetzt.

Weiterhin sind Leuchtdioden bekannt, bei denen auf einem GaP-Substrat mittels Epitaxie eine Schichtenfolge aus GaAsP aufgebracht ist. Diese Schichtenfolge weist beispielsweise ausgehend vom GaP-Substrat zunächst eine GaAsP-Übergangsschicht mit zunehmendem As-Gehalt, eine n-dotierte GaAsP-Schicht (Dotierstoff: z. b. Tellur oder Schwefel) und eine p-dotierte GaAsP-Schicht (Dotierstoff: Zink) auf. Auf die p-dotierte GaAsP-Schicht ist eine Kontaktmetallisierung aufgebracht, die beispielsweise ausgehend von der p-dotierten GaAsP-Schicht aus einer Gold-Zink-Schicht, einer TiWN-Schicht und einer Aluminium-Schicht besteht. Die Unterseite des GaP-Substrats ist mit einer Kontaktmetallisierung versehen, die beispielsweise aus einer auf dem GaP-Substrat aufgebrachten Gold-Germanium-Schicht besteht.

Je nach As-Gehalt kann mit einem oben beschriebenen Halbleiterkörper eine Leuchtdiode hergestellt werden, die Licht aus dem Bereich Gelb bis Superrot aussendet. Der Nachteil dieser Halbleiterkörper besteht jedoch darin, daß das im Halbleiterkörper erzeugte Licht nur zu einem Bruchteil aus dem Halbleiterkörper ausgekoppelt wird.

In der US-Patentschrift 4,582,952 ist eine Solarzelle beschrieben, die, ausgehend von einem transparenten GaP-Substrat, aus einer ersten p-dotierten GaAsP-Schicht mit abgestuftem As-Gehalt, aus einer zweiten p-dotierten GaAsP-Schicht, aus einer n-dotierten GaAsP-Schicht und aus einer GaP-Abdeckschicht aufgebaut ist. Das GaP-Substrat und die GaP-Abdeckschicht sind jeweils mit einer Mehrzahl von Metallkontakten versehen.

Der Wirkungsgrad einer lichtemittierenden Diode bzw. einer Photodiode oder Solarzelle wird zu einem wesentlichen Anteil von den beim Austreten bzw. Eintreten der Strahlung aus bzw. in den Halbleiterkörper auftretenden Verlusten bestimmt. Eine Hauptursache für diese Verluste ist der große Unterschied der Brechungsindices von Halbleitermaterial und angrenzendem Medium (z. B. Luft oder Kunststoffumhüllung). Dieser große Unterschied bewirkt einen sehr kleinen Grenzwinkel der Totalreflexion für den Durchtritt der Strahlung durch die Oberfläche des Halbleiterkörpers. Auf direktem Wege tritt aber nur derjenige Strahlungsanteil aus dem Halbleiterkörper aus, welcher unter einem kleineren Winkel zur Oberflächenormalen als der Grenzwinkel auf die Grenzfläche fällt. Der verbleibende Strahlungsanteil wird in den Halbleiterkörper zurückreflektiert. Aus US-A-5 429 954 ist ein Verfahren zum Herstellen einer lichtemittierende Diode mit einer durch Ätzen erzeugten Oberflächenaufrauhung bekannt. EP-A-0 198 199 beschreibt ein Verfahren zur Herstellung eine Oberflächengitters auf der Oberfläche eines Halbleitersubstrats aus GaAs mittels einer Ätzlösung aus Schwefelsäure, Wasserstoffperoxid und Wasser.

Die Aufgabe der Erfindung besteht darin, ein Verfahren zum Herstellen eines Licht aussendenden und/oder empfangenden Halbleiterkörpers mit mindestens einer Halbleiterschicht aus GaAsₓP₁₋ₓ mit 0 ≤ x < 1 zu entwickeln, der eine verbesserte Lichtaus- bzw. -einkoppelung aufweist.

Diese Aufgabe wird durch ein Verfahren mit den Merkmalen des Anspruches 1 gelöst. Vorteilhafte Weiterbildungen des erfindungsgemäßen Verfahrens sind Gegenstand der Unteransprüche 2 bis 9.

Erfindungsgemäß ist vorgesehen, daß zumindest ein Teil der Oberfläche der Halbleiterschicht in einem ersten Ätzschritt mit einer Ätzlösung der Zusammensetzung H₂SO₄:H₂O₂:H₂O und nachfolgend in einem zweiten Ätzschritt mit verdünnter Flußsäure behandelt wird, so daß zumindest auf einem Teil der Oberfläche der Halbleiterschicht eine Aufrauhung erzeugt wird.

Durch die Aufrauhung der Oberfläche wird vorteilhafterweise erreicht, daß im Vergleich zu einer ebenen Oberfläche ein größerer Anteil der in dem Halbleiterkörper erzeugten Strahlung in einem Winkel auf die Oberfläche der Halbleiterschicht trifft, der kleiner als der Grenzwinkel der Totalreflexion ist.

Ein weiterer Vorteil der aufgerauhten Halbleiteroberfläche besteht darin, daß bei einem Halbleiterbauelement, bei dem ein Halbleiterkörper unmittelbar von einer Kunststoffumhüllung umgeben ist, eine erhöhte Haftfestigkeit zwischen dem Halbleiterkörper und der Kunststoffumhüllung erzielt wird. Dadurch ist die Gefahr einer Ablösung der Kunststoffumhüllung vom Halbleiterkörper während des Betriebes und eine demzufolge beschleunigte Alterung des Halbleiterbauelements verringert.

Gemäß einer vorteilhaften Weiterbildung des erfindungsgemäßen Verfahrens wird bei einem Halbleiterkörper mit einem n-dotierten GaP-Substrat, auf dem eine Schichtenfolge aus GaAsP aufgebracht ist, die gesamte freie Oberfläche des Halbleiterkörpers aufgerauht. Unter freier Oberfläche ist hier der Teilbereich der Oberfläche zu verstehen, der nicht mit einer Kontaktmetallisierungsschicht versehen ist.

Bei Leuchdioden mit einem derartigen zur Lichterzeugung geeigneten Halbleiterkörper ist das GaP-Substrat für die in der GaAsP-Schichtenfolge erzeugte elektromagnetische Strahlung durchlässig, da der Bandabstand von GaAsP kleiner ist als der von GaP. Daher kann vorteilhafterweise die Strahlung durch die gesamte freie Oberfläche des Halbleiterkörpers hindurch aus diesem ausgekoppelt werden.

Vorteilhafterweise weist eine auf eine Unterseite des GaP-Substrats aufgebrachte Kontaktmetallisierung an der Grenze zum Halbleiterkörper eine Spiegelfläche auf. Dies hat zur Folge, daß die von der GaAsP-Schichtenfolge in Richtung der Kontaktmetallisierung ausgesandte Strahlung von dieser weitgehend reflektiert wird und nachfolgend durch die freie Oberfläche ausgekoppelt werden kann.

Bei einer bevorzugten Weiterbildung des erfindungsgemäßen Verfahrens, wird beim ersten Ätzschritt für die Ätzlösung H₂SO₄:H₂O₂:H₂O ein Verhältnis von 3:1:1, eine Temperatur zwischen 20 und 80° und eine Ätzdauer zwischen einer halben Minute und 10 Minuten gewählt. Mit dieser Maßnahme wird u. a. erreicht, daß die zu ätzende Oberfläche des Halbleiterkörpers vollständig von Verschmutzungen und anderen Rückständen befreit wird.

Bei einer weiteren bevorzugten Weiterbildung des erfindungsgemäßen Verfahrens und dessen Weiterbildungen wird beim zweiten Ätzschritt eine 40-50%ige Flußsäure verwendet. Der zweite Ätzschritt wird bei einer Temperatur zwischen 15 und 30°, insbesondere bei ca. 25° durchgeführt und dauert zwischen 30 Minuten und 120 Minuten.

Mittels der beiden oben angegebenen Ätzschritte wird vorteilhafter Weise eine Oberflächenaufrauhung erzielt, die die Gestalt von nebeneinander angeordneten Sägezähnen mit einer Höhe von ca. 1 µm aufweist. Bei Leuchtdioden kann dadurch vorteilhafterweise eine Lichtsteigerung von ca. 40% erzielt werden.

Bei einer anderen bevorzugten Weiterbildung des erfindungsgemäßen Verfahrens weist der Halbleiterkörper ein GaP-Substrat auf, auf dem eine Schichtenfolge aus Stickstoff(N)-dotiertem GaP (kurz: GaP:N) aufgebracht ist. Auch bei einem derartigen zur Lichterzeugung geeigneten Halbleiterkörper ist vorteilhafterweise das Substrat für die in der GaP-Schichtenfolge erzeugte Strahlung durchlässig, so daß auch hier durch die Aufrauhung der Halbleiteroberfläche eine wesentliche Steigerung der Lichtauskoppelung erzielt wird.

Bei einem besonders vorteilhaften Verfahren zum gleichzeitigen Herstellen einer Mehrzahl von Halbleiterkörpern der eingangs genannten Art wird zunächst auf einer Substratscheibe aus GaP eine Schichtenfolge aus GaAsₓP₁₋ₓ mit 0 ≤ x < 1 oder GaP:N aufgebracht. Nachfolgend wird auf die Unterseite der Substratscheibe eine erste Kontaktmetallisierung und auf die Oberseite der Schichtenfolge eine Mehrzahl von zweiten Kontaktmetallisierungen aufgebracht. Anschließend wir die freie Oberfläche der Schichtenfolge zunächst in einem ersten Ätzschritt mit der Ätzlösung der Zusammensetzung H₂SO₄:H₂O₂:H₂O und in einem zweiten Ätzschritt mit Flußsäure (HF) behandelt.

Abschließend wird die Halbleiterscheibe, bestehend aus Substratscheibe, Schichtenfolge, erster und zweiten Kontaktmetallisierungen zu einzelnen Halbleiterkörpern, z. B. Leuchtdiodenchips, vereinzelt.

ist vorgesehen, daß auch die Seitenflächen der Halbleiterkörper aufgerauht werden, so wird die Halbleiterscheibe nach dem Aufbringen der ersten und zweiten Kontaktmetallisierungen zum Beispiel auf eine Klebefolie oder ein anderes Haltemittel aufgebracht und in einzelne Leuchtdioden-Halbleiterkörper vereinzelt. Anschließend werden die beiden oben genannten Ätzschritte durchgeführt, bevor dann die vereinzelten Halbleiterkörper von dem Haltemittel abgehoben und z. B. zu Leuchtdioden weiterverarbeitet werden.

Das erfindungsgemäße Verfahren wird nun anhand von Ausführungsbeispielen in Verbindung mit den Figuren 1 bis 4 näher erläutert. Es zeigen:
Figur 1 eine schematische Darstellung eines Halbleiterkörpers, der gemäß einem ersten Ausführungsbeispiel des erfindungsgemäßen Verfahrens hergestellt wird,
Figur 2 eine schematische Darstellung eines Halbleiterkörpers, der nach einem zweiten Ausführungsbeispiel des erfindungsgemäßen Verfahrens hergestellt wird,
Figur 3 eine schematische Darstellung eines Verfahrensablaufes zum gleichzeitigen Herstellen einer Mehrzahl von Halbleiterkörpern mit aufgerauhter Oberfläche gemäß dem ersten Ausführungsbeispiel des erfindungsgemäßen Verfahrens und
Figur 4 eine schematische Darstellung eines Verfahrensablaufes zum gleichzeitigen Herstellen einer Mehrzahl von Halbleiterkörpern mit aufgerauhter Oberfläche gemäß dem zweiten Ausführungsbeispiel des erfindungsgemäßen Verfahrens.

In den Figuren sind gleiche Teile immer mit denselben Bezugszeichen versehen.

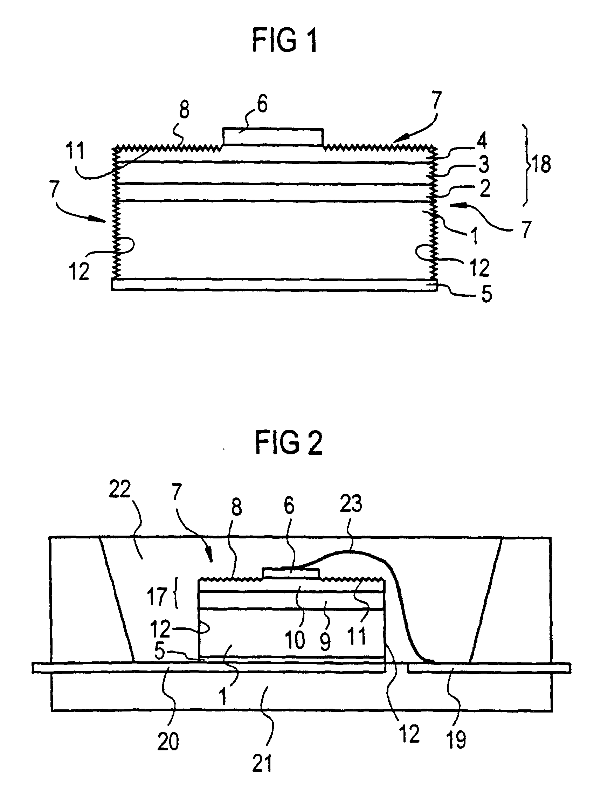

Bei dem in Figur 1 dargestellten Halbleiterkörper handelt es sich um einen Licht aussendenden Halbleiterkörper, z. B. um einen Leuchtdioden-Halbleiterkörper. Hierbei ist auf einem GaP-Substrats 1 eine Licht aussendende Schichtenfolge 18 angeordnet. Auf dem GaP-Substrat 1 ist beispielsweise eine erste GaAsₓP₁₋ₓ-Epitaxieschicht 2 mit 0 ≤ x < 1 aufgebracht, über der wiederum eine beispielsweise n-dotierte zweite GaAsₓP₁₋ₓ-Epitaxieschicht 3 mit 0 ≤ x < 1 angeordnet ist. Als n-Dotierstoff kann beispielsweise Te oder S verwendet sein.

Auf der zweiten GaAsₓP₁₋ₓ-Epitaxieschicht 3 ist eine z. B. p-dotierte dritte GaAsₓP₁₋ₓ-Epitaxieschicht 4 mit 0 ≤ x < 1 aufgebracht, die beispielsweise mit Zn dotiert ist. Die erste GaAsₓP₁₋ₓ-Epitaxieschicht 2 weist ausgehend vom GaP-Substrat 1 einen zunehmenden As-Gehalt auf, z. B. von x = 0 bis x = As-Gehalt der zweiten GaAsₓP₁₋ₓ-Epitaxieschicht 4.

Die Unterseite des GaP-Substrats 1 ist mit einer ersten Kontaktmetallisierung 5 versehen, die beispielsweise aus einer Schichtenfolge Au-Ge-Legierung/Ag/Au besteht. Auf der Oberseite der dritten GaAsₓP₁₋ₓ-Epitaxieschicht 4 ist eine zweite Kontaktmetallisierung 6 aufgebracht. Diese weist z. B. eine unmittelbar auf die dritte GaAsₓP₁₋ₓ-Epitaxieschicht 4 aufgebrachten Au-Zn-Schicht und eine auf dieser aufgebrachten Au-Schicht auf. Für die Kontaktmetallisierungen 5 und 6 kann aber auch jede andere dem Fachmann als geeignet bekannte Material- und Schichtenkombination verwendet werden.

Die gesamte freie Oberfläche 7, d. h. die nicht von der ersten 5 und zweiten 6 Kontaktmetallisierung abgedeckten Oberfläche des Halbleiterkörpers, in diesem Falls ist dies ein Teil der Oberseite 11 und die Seitenflächen 12, ist mit einer Aufrauhung 8 versehen. Diese weist eine Struktur von nebeneinander angeordneten Sägezähnen (Höhe z. B. ca. 1 µm) auf.

Das Verfahren zum Herstellen der Aufrauhung 8 besteht aus einem ersten und zweiten Ätzschritt, wobei die freie Oberfläche 7 des Halbleiterkörpers beim ersten Ätzschritt mit einer Ätzlösung der Zusammensetzung H₂SO₄:H₂O₂:H₂O (3:1:1) und beim zweiten Ätzschritt mit Flußsäure (40 bis 50%) behandelt wird.

Der erste Ätzschritt wird bei einer Temperatur von zwischen 15 und 80°, insbesondere 25°C durchgeführt und dauert zwischen 30 Sekunden und 10 Minuten. Der zweite Ätzschritt wird bei einer Temperatur zwischen 15 und 30°C durchgeführt und dauert zwischen 30 Minuten und 120 Minuten.

Der in Figur 2 dargestellte Halbleiterkörper, ebenfalls ein Licht aussendender Halbleiterkörper, weist wiederum ein GaP-Substrat 1 auf. Auf dem GaP-Substrat ist eine n-dotierte erste GaP:N-Epitaxieschicht 9 aufgebracht, über der eine p-dotierte zweite GaP:N-Epitaxieschicht 10 angeordnet ist. Durch die N-Dotierung von GaP wird eine Verkleinerung der Bandlücke erreicht, wodurch bewirkt ist, daß das GaP-Substrat wiederum für das in der Schichtenfolge 17 aus erster 9 und zweiter 10 GaP:N-Epitaxieschicht erzeugte Licht transparent ist.

Ein weiterer Unterschied zu dem in Figur 1 gezeigten Halbleiterkörper besteht darin, daß hier nur die Oberseite 11 des Halbleiterkörpers mit einer Aufrauhung 8 versehen ist und die Seitenflächen 12 nicht aufgerauht sind. Das zum Herstellen der Aufrauhung 8 eingesetzte Verfahren entspricht beispielsweise dem in Verbindung mit Figur 1 erläuterten Verfahren.

Weiterhin ist in Figur 2 beispielhaft dargestellt, wie der Halbleiterkörper in ein herkömmliches LED-Gehäuse, bestehend aus einem ersten 19 und einem zweiten 20 elektrischen Anschluß, einem lichtundurchlässigen Grundkörper 21 und einer lichtdurchlässigen Umhüllung 22, eingebaut sein kann. Hierbei ist der Halbleiterkörper beispielsweise mittels eines elektrisch leitenden Lotes oder Klebstoffes mit seiner ersten Kontaktmetallisierung 5 auf dem zweiten elektrischen Anschluß 20 befestigt. Die zweite Kontaktmetallisierung 6 ist mittels eines Bonddrahtes 23 mit dem ersten elektrischen Anschluß 19 verbunden. Der Grundkörper 21 umschließt teilweise die elektrischen Anschlüsse 19,20 und weist eine Ausnehmung auf, in der der Halbleiterkörper angeordnet ist. Die Ausnehmung ist beispielsweise derart geformt, daß sie für das von dem Halbleiterkörper ausgekoppelte Licht einen Reflektor bildet. Auβerdem ist die Ausnehmung mit der lichtdurchlässigen Umhüllung 22 gefüllt, die unmittelbar an die freie Oberfläche 7 des Halbleiterkörpers grenzt. Die Umhüllung 22 besteht beispielsweise aus einem transparenten Kunstharz und bildet mit der Aufrauhung 8 des Halbleiterkörpers eine Mikroverzahnung aus, die die Haftfestigkeit der Umhüllung 22 auf dem Halbleiterkörper erhöht und damit die Gefahr einer Delamination deutlich senkt.

Der Vollständigkeit halber sei erwähnt, daß selbstverständlich auch der Halbleiterkörper von Figur 1 in ein derartiges Gehäuse eingebaut werden kann. Die Mikroverzahnung bildet sich dann natürlich nicht nur an der Oberseite des Halbleiterkörpers sondern auch an dessen Seitenflächen aus. Ebenso kann das Gehäuse auch einstückig aus einem transparenten Kunststoff gefertigt sein und eine beliebige Form aufweisen.

Durch das Aufrauhen der freien Oberfläche der Halbleiterkörper wird beispielsweise bei Leuchtdioden, die mit den oben beschriebenen Halbleiterkörpern versehen sind, eine Lichtsteigerung von mehr als 40% erzielt.

Selbstverständlich kann auch der Halbleiterkörper von Figur 1 derart hergestellt werden, daß er nur auf seiner Oberseite 11 eine Aufrauhung 8 aufweist. Ebenso kann der Halbleiterkörper von Figur 2 über seine gesamte freie Oberfläche 7 mit einer Aufrauhung 8 versehen werden.

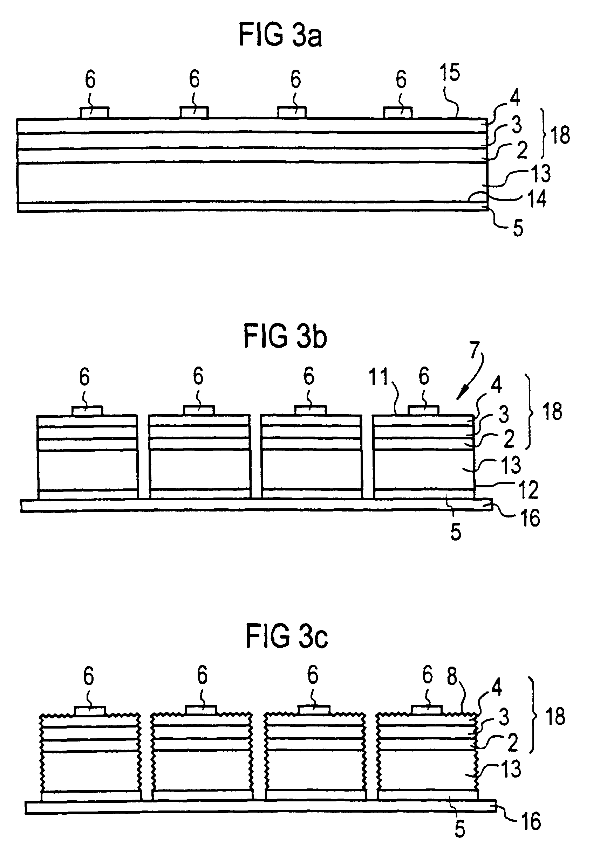

Bei dem in Figur 3 schematisch dargestellten Verfahrensablauf zum gleichzeitigen Herstellen einer Mehrzahl von Halbleiterkörpern gemäß Figur 1 wird zunächst (Teilbild A) auf eine vorgefertigte GaP-Substratscheibe 13 die erste GaAsₓP₁₋ₓ-Epitaxieschicht 2, die zweite GaAsₓP₁₋ₓ-Epitaxieschicht 3 und die dritte GaAsₓP₁₋ₓ-Epitaxieschicht 4 aufgebracht. Die Unterseite 14 der Substratscheibe 13 wird mit der Kontaktmetallisierung 5 versehen. Auf die Oberseite 15 der dritten GaAsₓP₁₋ₓ-Epitaxieschicht 4 wird eine Mehrzahl von zweiten Kontaktmetallisierungen 6 aufgebracht. Die Kontaktmetallisierungen 5,6 werden beispielsweise mittels Aufdampfen oder Sputtern hergestellt.

Anschließend (Teilbild B) wird die Halbleiterscheibe, bestehend aus dem GaP-Substrat, der ersten 2, zweiten 3 und dritten 4 GaAsₓP₁₋ₓ-Epitaxieschicht, der ersten 5 und den zweiten 6 Kontaktmetallisierungen, auf ein Haltemittel 16, beispielsweise eine Klebefolie, aufgebracht und in einzelne Halbleiterkörper vereinzelt. Dies erfolgt beispielsweise mittels Sägen.

Nachfolgend (Teilbild C) werden dann die freien Oberflächen, also jeweils ein Teil der Oberseite 11 und die Seitenflächen 12 (Schnittflanken) der Halbleiterkörper, wie weiter oben erläutert, mittels dem ersten und dem zweiten Ätzschritt aufgerauht. Die fertiggestellten, aufgerauhten Halbleiterkörper können dann von dem Haltemittel 16 abgetrennt und beispielsweise zu Leuchtdioden weiterverarbeitet werden.

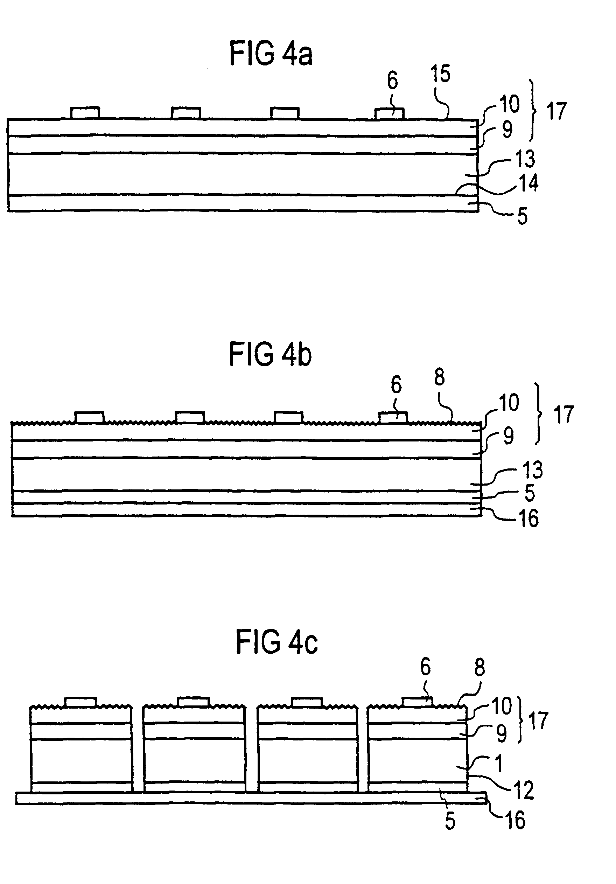

Der in Figur 4 schematisch dargestellte Verfahrensablauf zum gleichzeitigen Herstellen einer Mehrzahl von Halbleiterkörpern gemäß Figur 2 unterscheidet sich von dem von Figur 3 im wesentlichen dadurch, daß der erste und der zweite Ätzschritt vor dem Vereinzeln der Halbleiterscheibe durchgeführt wird. Dadurch wird erreicht, daß nur ein Teil, nämlich der nicht von den Kontaktmetallisierungen 6 abgedeckte Teil der Oberseite 11 der Halbleiterscheibe mit einer Aufrauhung 8 versehen wird.

Ebenso kann vorgesehen sein, daß nur die Oberseite 11 und Teilbereiche der Seitenflächen 12 der Halbleiterkörper eine Aufrauhung 8 aufweisen. In diesem Fall wird die Halbleiterscheibe vor den Ätzschritten nicht vollständig durchsägt sondern nur angesägt und erst nach dem Ätzen vereinzelt.

Wird für die zweiten Kontaktmetallisierungen 6 ein Material verwendet, das bei einem der beiden Ätzschritte angegriffen würde, so können diese vorher mit einer gegen die Ätzlösung resistenten Abdeckschicht abgedeckt werden. Diese Abdeckschicht wird nach dem Aufrauhen dann wieder entfernt.

## Patentansprüche

1. Verfahren zum Herstellen eines Licht aussendenden und/oder empfangenden Halbleiterkörpers mit mindestens einer Halbleiterschicht, die aus GaAsₓP₁₋ₓ mit 0 ≤ X < 1 besteht, **dadurch gekennzeichnet, daß** zumindest ein Teil der Oberfläche der Halbleiterschicht in einem ersten Ätzschritt mit einer Ätzlösung der Zusammensetzung H₂SO₄:H₂O₂:H₂O und nachfolgend in einem zweiten Ätzschritt mit Flußsäure behandelt wird, so daß zumindest auf dem Teil der Oberfläche der Halbleiterschicht eine Aufrauhung (8) erzeugt wird.

2. Verfahren nach Anspruch 1, **dadurch gekennzeichnet, daß** die Aufrauhung (8) die Gestalt von nebeneinander angeordneten Sägezähnen aufweist.

3. Verfahren nach Anspruch 1 oder 2, **dadurch gekennzeichnet, daß** ein Halbleiterkörper mit einem GaP-Substrat verwendet wird, auf dem eine Schichtenfolge (17,18) aufgebracht ist, die mindestens eine mit Stickstoff dotierte GaP-Epitaxieschicht aufweist.

4. Verfahren nach Anspruch 1 oder 2, **dadurch gekennzeichnet, daß** ein Halbleiterkörper mit einem GaP-Substrat verwendet wird, auf dem eine Schichtenfolge (17,18) aufgebracht ist, die mindestens eine GaAsₓP₁₋ₓ-Epitaxieschicht mit 0 < x < 1 aufweist.

5. Verfahren nach einem der Ansprüche 1 bis 4, **dadurch gekennzeichnet, daß** die gesamte freie Oberfläche (7) des Halbleiterkörpers die Aufrauhung (8) aufweist.

6. Verfahren zum gleichzeitigen Herstellen einer Mehrzahl von Licht aussendenden und/oder empfangenden Halbleiterkörpern mit mindestens einer Halbleiterschicht, die aus GaAsₓP₁₋ₓ mit 0 ≤ x < 1 bzw. aus GaP:N besteht, das die folgenden Schritte enthält:
a) zunächst wird auf eine Substratscheibe (13) aus GaP eine Schichtenfolge (17,18) aus GaAsₓP₁₋ₓ mit 0 ≤ x < 1 aufgebracht,
b) auf die Unterseite (14) der Substratscheibe (13) wird eine erste Kontaktmetallisierung (5) und auf die Oberseite (15) der Schichtenfolge (17,18) mindestens eine zweite Kontaktmetallisierung (6) aufgebracht ,
c) die freie Oberfläche der Schichtenfolge (17, 18) wird zunächst in einem ersten Ätzschritt mit einer Ätzlösung der Zusammensetzung H₂SO₄:H₂O₂:H₂O und in einem zweiten Ätzschritt mit Flußsäure (HF) behandelt , so daß eine Aufrauhung (8) der freien Oberfläche erzeugt wird und
d) die Halbleiterscheibe, bestehend aus der Substratscheibe (13), der Schichtenfolge (17, 18), der ersten (5) und den zweiten (6) Kontaktmetallisierungen wird zu einzelnen Halbleiterkörpern vereinzelt.

7. Verfahren zum gleichzeitigen Herstellen einer Mehrzahl von Licht aussendenden und/oder empfangenden Halbleiterkörpern mit mindestens einer Halbleiterschicht, die aus GaAsₓP₁₋ₓ mit 0 ≤ x < 1 bzw. aus GaP:N besteht, das die folgenden Schritte enthält:
a) zunächst wird auf eine Substratscheibe (13) aus GaP eine Schichtenfolge (17,18) aus GaAsₓP₁₋ₓ mit 0 ≤ x < 1 aufgebracht,
b) auf die Unterseite (14) der Substratscheibe (13) wird eine erste Kontaktmetallisierung (5) und auf die Oberseite (15) der Schichtenfolge (17,18) eine Mehrzahl von zweiten Kontaktmetallisierungen (6) aufgebracht,
c) die Halbleiterscheibe, bestehend aus der Substratscheibe (13), der Schichtenfolge (17,18), der ersten (5) und den zweiten (6) Kontaktmetallisierungen, wird auf einem Haltemittel (16) aufgebracht ,
d) die Halbleiterscheibe wird zu einzelnen Halbleiterkörpern vereinzelt und
e) die freien Oberflächen der Halbleiterkörper werden zunächst in einem ersten Ätzschritt mit einer Ätzlösung der Zusammensetzung H₂SO₄:H₂O₂:H₂O und in einem zweiten Ätzschritt mit Flußsäure (HF) behandelt , so daß eine Aufrauhung (8) der Oberflächen erzeugt wird.

8. Verfahren nach einem der Ansprüche 1 bis 7, **dadurch gekennzeichnet, daß** beim ersten Ätzschritt für die Ätzlösung H₂SO₄:H₂O₂:H₂O ein Verhältnis von 3:1:1, eine Temperatur zwischen 15 und 80°C und eine Ätzdauer zwischen einer halben Minute und 10 Minuten gewählt wird.

9. Verfahren nach einem der Ansprüche 1 bis 8, **dadurch gekennzeichnet, daß** beim zweiten Ätzschritt eine 40-50%ige Flußsäure, eine Temperatur zwischen 15 und 30°C und eine Ätzdauer zwischen 30 Minuten und 120 Minuten gewählt wird.

## Claims

1. Process for producing a light-emitting and/or - receiving semiconductor body having at least one semiconductor layer composed of GaAsₓP₁₋ₓ, where 0 ≤ X < 1, **characterized in that** at least one part of the surface of the semiconductor layer is treated with an etching solution having the composition H₂SO₄:H₂O₂:H₂O in a first etching step and then with hydrofluoric acid in a second etching step, with the result that a roughness (8) is produced at least on the part of the surface of the semiconductor layer.

2. Process according to Claim 1, **characterized in that** the roughness (8) has the shape of saw teeth which are arranged next to one another.

3. Process according to Claim 1 or 2, **characterized in that** use is made of a semiconductor body with a GaP substrate on which is applied a layer sequence (17,18) having at least one nitrogen-doped GaP epitaxial layer.

4. Process according to Claim 1 or 2, **characterized in that** use is made of a semiconductor body with a GaP substrate on which is applied a layer sequence (17,18) having at least one GaAsₓP₁₋ₓ epitaxial layer, where 0 < x < 1.

5. Process according to one of Claims 1 to 4, **characterized in that** the entire free surface (7) of the semiconductor body has the roughness (8).

6. Process for simultaneously producing a plurality of light-emitting and/or -receiving semiconductor bodies having at least one semiconductor layer which is composed of GaAsₓP₁₋ₓ, where 0 ≤ x < 1, or of GaP:N which comprises the following steps:
a) a layer sequence (17,18) made of GaAsₓP₁₋ₓ, where 0 ≤ x < 1 is firstly applied to a substrate wafer (13) made of GaP,
b) a first contact metallization layer (5) is applied to the underside (14) of the substrate wafer (13) and at least one second contact metallization layer (6) is applied to the top side (15) of the layer sequence (17,18),
c) the free surface of the layer sequence (17,18) is firstly treated with an etching solution having the composition H₂SO₄:H₂O₂:H₂O in a first etching step and with hydrofluoric acid (HF) in a second etching step, with the result that a roughness (8) of the free surface is produced, and
d) the semiconductor wafer, comprising the substrate wafer (13), the layer sequence (17,18), the first (5) and the second (6) contact metallization layers, is separated to form individual semiconductor bodies.

7. Process for simultaneously producing a plurality of light-emitting and/or -receiving semiconductor bodies having at least one semiconductor layer which is composed of GaAsₓP₁₋ₓ, where 0 ≤ x < 1, or of GaP:N, which comprises the following steps:
a) a layer sequence (17,18) made of GaAsₓP₁₋ₓ, where 0 ≤ x < 1 is firstly applied to a substrate wafer (13) made of GaP,
b) a first contact metallization layer (5) is applied to the underside (14) of the substrate wafer (13) and a plurality of second contact metallization layers (6) are applied to the top side (15) of the layer sequence (17,18),
c) the semiconductor wafer, comprising the substrate wafer (13), the layer sequence (17,18), the first (5) and the second (6) contact metallization layers, is placed on a holding means (16),
d) the semiconductor wafer is separated to form individual semiconductor bodies, and
e) the free surfaces of the semiconductor bodies are firstly treated with an etching solution having the composition H₂SO₄:H₂O₂:H₂O in a first etching step and with hydrofluoric acid (HF) in a second etching step, with the result that a roughness (8) of the surfaces is produced.

8. Process according to one of Claims 1 to 7, **characterized in that**, in the case of the first etching step, a ratio of 3:1:1 is chosen for the etching solution H₂SO₄:H₂O₂:H₂O, a temperature of between 15 and 80°C is chosen and an etching duration of between half a minute and 10 minutes is chosen.

9. Process according to one of Claims 1 to 8, **characterized in that**, in the case of the second etching step, hydrofluoric acid with a concentration of 40-50% is chosen, a temperature of between 15 and 30°C is chosen and an etching duration of between 30 minutes and 120 minutes is chosen.

## Revendications

1. Procédé de fabrication d'un corps semi-conducteur émettant et/ou recevant de la lumière et comprenant au moins une couche semi-conductrice qui est en GaAsₓP₁₋ₓ avec 0 ≤ X < 1, **caractérisé en ce que** l'on traite au moins une partie de la surface de la couche semi-conductrice dans un premier stade d'attaque par une solution d'attaque ayant la composition H₂SO₄ :H₂O₂:H₂O et ensuite dans un deuxième stade d'attaque par de l'acide fluorhydrique de manière à produire une rugosité (8) au moins sur la partie de la surface de la couche semi-conductrice.

2. Procédé selon la revendication 1, **caractérisé en ce que** la rugosité (8) a la forme de dents de scie disposées les unes à côté des autres.

3. Procédé selon la revendication 1 ou 2, **caractérisé en ce que** l'on utilise un corps semi-conducteur qui a un substrat en GaP sur lequel est déposée une succession (17, 18) de couches qui comprend au moins une couche d'épitaxie en GaP dopée par de l'azote.

4. Procédé suivant la revendication 1 ou 2, **caractérisé en ce que** l'on utilise un corps semi-conducteur ayant un substrat en GaP sur lequel est déposée une succession (17, 18) de couches qui comprend au moins une couche d'épitaxie en GaASₓP₁₋ₓ avec 0 < x < 1.

5. Procédé suivant l'une des revendications 1 à 4, **caractérisé en ce que** toute la surface (7) libre du corps semi-conducteur comporte la rugosité (8).

6. Procédé de fabrication simultané d'une pluralité de corps semi-conducteurs émettant et/ou recevant de la lumière et comprenant au moins une couche semi-conductrice qui est en GaAsₓP₁₋ₓ avec 0 ≤ x < 1, ou en GaP:N qui comporte les stades suivants :
a) on dépose d'abord sur une tranche (13) de substrat en GaP une succession (17, 18) de couches en GaAsₓP₁₋ₓ avec 0 ≤ x < 1,
b) on dépose sur la face (14) inférieure de la tranche (13) formant le substrat une première métallisation (5) de contact et sur la face (15) supérieure de la succession (17, 18) de couches au moins une deuxième métallisation (6) de contact,
c) on traite la surface libre de la succession (17, 18) de couches d'abord dans un premier stade d'attaque par une solution d'attaque ayant la composition H₂SO₄:H₂O₂:H₂O et dans un deuxième stade d'attaque par de l'acide flurhydrique (HF), de manière à produire une rugosité (8) de la surface libre, et
d) on sépare les tranches semi-conductrices constituées de la tranche (13) formant substrat de la succession (17, 18) de couches, de la première (5) et de la deuxième (6) métallisations de contact en des corps semi-conducteurs individuels.

7. Procédé de fabrication simultané d'une pluralité de corps semi-conducteurs émettant et/ou recevant de la lumière et comprenant au moins une couche semi-conductrice qui est en GaAsₓP₁₋ₓ avec 0 ≤ x < 1, ou en GaP:N qui comporte les stades suivants :
a) on dépose d'abord sur une tranche (13) de substrat en GaP une succession (17, 18) de couches en GaAsₓP₁₋ₓ avec 0 ≤ x < 1,
b) on dépose sur la face (14) inférieure de la tranche (13) formant substrat une première métallisation (5) de contact et sur la face (15) supérieure de la succession (17, 18) de couches au moins une pluralité de deuxièmes métallisations (6) de contact,
c) on applique la tranche semi-conductrice constituée de la tranche (13) formant un substrat de la succession (17, 18) de couches de la première (5) et de la deuxième (6) métallisations de contact par un moyen (16) de maintien,
d) on sépare la tranche semi-conductrice en des corps semi-conducteurs individuels, et
e) on traite les surfaces libres des corps semi-conducteurs d'abord dans un premier stade d'attaque par une solution d'attaque ayant la composition H₂SO₄:H₂O₂:H₂O et dans un deuxième stade d'attaque, par de l'acide fluorhydrique (HF) de manière à produire une rugosité (8) des surfaces.

8. Procédé suivant l'une des revendications 1 à 7, **caractérisé en ce que** l'on choisit pour le premier stade d'attaque pour la solution d'attaque H₂SO₄:H₂O₂:H₂O un rapport de 3:1:1, une température comprise entre 15 et 80°C et une durée d'attaque comprise entre une demi-minute et 10 minutes.

9. Procédé suivant l'une des revendications 1 à 8, **caractérisé en ce qu'**on choisit pour le deuxième stade d'attaque de l'acide fluorhydrique à 40 à 50 %, une température comprise entre 15 et 30°C et une durée d'attaque comprise entre 30 minutes et 120 minutes.
